# EUROPÄISCHE PATENTANMELDUNG

(11) **EP 1 134 891 A1**
(43) Veröffentlichungstag der Anmeldung: **19.09.2001**
(21) Anmeldenummer: 00104820.6
(22) Anmeldetag: 06.03.2000
(51) Int. Cl.: H03F 1/30

(54) **Schaltungsanordnung zur Arbeitspunkteinstellung eines Hochfrequenztransistors und Verstärkerschaltung**

(71) Anmelder: Infineon Technologies AG, 81669 München (DE)
(72) Erfinder: Schaffer, Josef-Paul, 85604 Zorneding (DE)
(74) Vertreter: Hermann, Uwe, Dipl.-Ing.

(57) **Zusammenfassung**

Eine Verstärkerschaltung mit einem Hochfrequenztransistor (1) weist eine Schaltung (2) zur Arbeitspunkteinstellung auf, die in Abhängigkeit von der an einem in den Kollektorkreis des Hochfrequenztransistors (1) geschalteten Widerstand (3) abfallenden Spannung einen Basisstrom (IB) für den Hochfrequenztransistor (1) bereitstellt. Die Schaltung (2) weist ein von der Versorgungsspannung (VS, GND) gespeistes Differenzglied (20) auf, welches die am Widerstand (3) abfallende Spannung mit einer Referenzspannung vergleicht. Der Basisstrom (IB) wird in Abhängigkeit von der Spannungsdifferenz von einer Stromquelle (22) erzeugt. Die Schaltung (2) benötigt nur eine niedrige Versorgungsspannung, so daß auch die im Widerstand (3) verbrauchte Leistung gering ist. Die Schaltung (2) kann mit einer geringen Anzahl von Bauelementen realisiert werden.

## Beschreibung

Die Erfindung betrifft eine Schaltungsanordnung zur Arbeitspunkteinstellung eines Hochfrequenztransistors mit Anschlüssen für Versorgungspotentiale sowie einem Anschluß für einen Meßwiderstand und eine Verstärkerschaltung mit einem Hochfrequenztransistor und einer solchen Schaltungsanordnung.

Verstärkerschaltungen für Hochfrequenzsignale weisen einen Hochfrequenztransistor auf, dem das zu verstärkende Signal an einem Steuereingang zuführbar ist und bei dem das verstärkte Signal am Lastkreis ausgekoppelt wird. Durch geeignete Gleichstromeinprägung am Steuereingang und am Laststrompfad wird der Transistor in seinem Arbeitspunkt gehalten.

Abhängig vom Versorgungsstrom haben Verstärkerschaltungen mit Hochfrequenztransistoren unterschiedliche Verstärkungseigenschaften. Es werden daher Widerstandsnetzwerke oder aktive Schaltungen angewandt, um den Arbeitspunkt des Verstärkertransistors möglichst unabhängig von dessen Fertigungstoleranzen und dessen Temperaturverhalten einzustellen.

Eine Schaltungsanordnung zur Arbeitspunkteinstellung für einen Hochfrequenztransistor ist beispielsweise die Schaltung BCR 400 von Infineon Technologies, wie beispielsweise im Datenblatt zur integrierten Schaltung BCR 400W vom 24. Februar 1999 gezeigt. Die Schaltung weist zwei Anschlüsse für eine Versorgungsspannung sowie einen Meßanschluß zum Anschluß eines Meßwiderstands sowie einen Stromausgang zum Anschluß an die Basis eines bipolaren Hochfrequenztransistors auf. Der zwischen Meßanschluß und dem positiven Pol der Versorgungsspannung geschaltete externe Meßwiderstand ist in den Kollektorstrompfad des Hochfrequenztransistors geschaltet. Der externe Meßwiderstand beträgt 100 bis 220 Ω. Der an diesem externen Widerstand anliegende Spannungsabfall beträgt cirka 600 mV. Bei Geräten mit niedriger Versorgungsspannung, insbesondere batteriebetriebenen Geräten, wird dadurch die maximale Ausgangsleistung der Verstärkerschaltung begrenzt. Durch den nicht unerheblichen Stromverbrauch am Meßwiderstand wird die Betriebszeit eines batteriebetriebenen Geräts eingeschränkt.

Die Aufgabe der Erfindung besteht darin, eine Schaltungsanordnung zur Arbeitspunkteinstellung eines Hochfrequenztransistors anzugeben, die bei niedriger Versorgungsspannung arbeiten kann und einen geringen Leistungsverbrauch aufweist.

Eine weitere Aufgabe besteht darin, eine Verstärkerschaltung mit einer solchen Schaltungsanordnung zur Arbeitspunkteinstellung anzugeben.

Gemäß der Erfindung wird die Aufgabe betreffend die Schaltungsanordnung zur Arbeitspunkteinstellung gelöst durch eine Schaltungsanordnung zur Arbeitspunkteinstellung eines Hochfrequenztransistors, umfassend: einen Anschluß für ein erstes Versorgungspotential und einen Anschluß für ein zweites Versorgungspotential; einen Meßanschluß, an den ein Meßwiderstand anzuschließen ist, der in Reihe mit dem Laststrompfad eines Hochfrequenztransistors geschaltet ist; einen Ausgangsanschluß, an den ein Steueranschluß des Hochfrequenztransistors zu koppeln ist; ein Differenzglied, das versorgungsspannungsmäßig mit den Anschlüssen für das erste und das zweite Versorgungspotential verbunden ist und einen ersten Signaleingang aufweist, der mit einer Referenzspannungsquelle verbunden ist, und einen zweiten Signaleingang der mit dem Meßanschluß verbunden ist; und eine vom Differenzglied gesteuerte Stromquelle, die mit dem Ausgangsanschluß verbunden ist.

Eine Verstärkerschaltung mit einer solchen Schaltungsanordnung weist auf: einen Widerstand, der zwischen den Anschluß für das erste Versorgungspotential und den Meßanschluß der Schaltungsanordnung geschaltet ist und einen Hochfrequenztransistor, dessen Kollektor mit dem Meßanschluß der Schaltungsanordnung und dessen Basis mit dem Ausgangsanschluß der Schaltungsanordnung gleichstrommäßig gekoppelt sind, dessen Basis mit einem Eingangsanschluß für ein hochfrequentes Eingangssignal und dessen Kollektor mit einem Ausgangsanschluß für ein hochfrequentes Ausgangssignal gekoppelt sind.

Die Schaltungsanordnung gemäß der Erfindung weist ein von der Versorgungsspannung gespeistes Differenzglied auf, welches die Spannung am Meßwiderstand mit einer Referenzspannung vergleicht. Abhängig davon wird der Strom einer Stromquelle gesteuert, die an den Steueranschluß des Hochfrequenztransistors, beispielsweise den Basisanschluß eines bipolaren HF-Transistors anzuschließen ist. Durch die Differenzbildung ist es möglich, eine niedrige Referenzspannung vorzusehen, mit der die am externen Meßwiderstand abfallende Spannung zu vergleichen ist. In der Praxis liegt die Referenzspannung bei circa 100 mV. Die Differenz der beiden Spannungen steuert den Stromausgang der Schaltung.

In Ausgestaltung der Erfindung ist eine erste Stromspiegelschaltung vorgesehen, deren Eingangspfad von einer Stromquelle gespeist wird und in deren Ausgangspfad ein Widerstand geschaltet ist, an dem die Referenzspannung abfällt. Der Steueranschluß eines ersten Transistors ist an die die Ein- und Ausgangszweige der ersten Stromspiegelschaltung verbindende Steuerleitung angeschlossen. Laststromseitig ist der Meßwiderstand an den ersten Transistor anzuschließen. Der Laststrom des ersten Transistors wird in Abhängigkeit von der Differenz zwischen der am Meßwiderstand anliegenden Spannung und der am Widerstand im ersten Stromspiegel erzeugten Referenzspannung gesteuert. Über einen zweiten Stromspiegel wird ein in Emitterschaltung betriebener Ausgangstransistor strommäßig angesteuert. Der Laststrom dieses Ausgangstransistors oder zweiten Transistors dient zur Stromeinprägung in den Steueranschluß des Hochfrequenztransistors. Anstelle eines einzigen Ausgangstransistors eignet sich auch eine Darlington-Schaltung aus mindestens zwei Transistoren, die eine höhere Stromtreiberfähigkeit aufweist.

Die Stromquelle im Eingangszweig der ersten Stromspiegelschaltung wird auf herkömmliche Weise gebildet. Hierzu ist ein Transistor vorgesehen, dessen Laststrompfad über einen Widerstand mit Bezugspotential verbunden ist und dessen Steueranschluß über die Reihenschaltung mehrerer Dioden ebenfalls mit Bezugspotential verbunden ist. Am anderen Anschluß des Laststrompfads dieses Transistors ist ein Konstantstrom abgreifbar.

Der erste Stromspiegel ist in herkömmlicher Weise realisiert, indem Steueranschluß und Laststrompfad des Transistors im Eingangszweig gekoppelt sind. Der Steueranschluß dieses Transistors ist außerdem an den Steueranschluß des Transistors im Ausgangszweig angeschlossen.

Die Transistoren im ersten Stromspiegel sind bipolare pnp-Transistoren. Ebenfalls sind der den Differenzverstärker bildende zweite Transistor sowie der ausgangsseitige Stromquellentransistor bipolare pnp-Transistoren. Die Schaltungsanordnung kann anstelle von bipolaren Transistoren mit MOS-Transistoren realisiert werden. Dabei sind npn-Transistoren durch n-Kanal-MOS-Transistoren zu ersetzen und pnp-Transistoren durch p-Kanal-MOS-Transistoren.

Die erfindungsgemäße Schaltung hat den Vorteil, daß nur relativ wenige Bauelemente erforderlich sind. Aufgrund der geringen Komplexität paßt die Schaltung in ein kleines, kostengünstiges Standardgehäuse. Die Stromregelung der Schaltung setzt bereits bei geringer Betriebsspannung von etwa 2 Volt ein. Die Signale im Regelkreis weisen keine Phasendrehung auf, so daß die Regelung eine hohe Stabilität hat. Das Temperaturverhalten der Schaltung verhält sich umgekehrt zum Temperaturverhalten eines bipolaren Verstärkertransistors, so daß die Verstärkungsschaltung insgesamt weitgehend temperaturstabiles Verstärkungsverhalten hat.

Nachfolgend wird die Erfindung anhand des in der Zeichnung dargestellten Ausführungsbeispiels im Detail erläutert. Es zeigen:
- Figur 1: ein Blockschaltbild der Verstärkerschaltung einschließlich einer in einem integrierten Schaltkreis realisierten Schaltungsanordnung zur Arbeitspunkteinstellung und
- Figur 2: eine Realisierung der Schaltungsanordnung zur Arbeitspunkteinstellung auf Transistorebene.

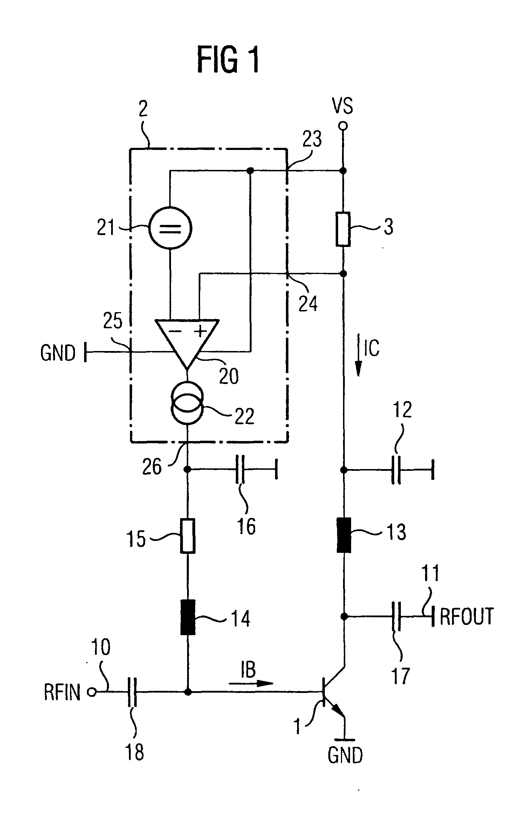

Die in Figur 1 gezeigte Verstärkerschaltung weist einen bipolaren npn-Hochfrequenztransistor 1 auf, dessen Basisanschluß mit einem Eingangsanschluß 10 für das zu verstärkende Hochfrequenzsignal RFIN verbunden ist und dessen Kollektoranschluß über einen Widerstand 3 zur Arbeitspunkteinstellung an ein positives Versorgungspotential VS angeschlossen ist. Der Emitter des Transistors 1 ist an Bezugspotential (Masse) GND angeschlossen. Das Hochfrequenzausgangssignal RFOUT ist an einem an den Kollektor des Transistors 1 angeschlossenen Ausgangsanschluß 11 abgreifbar. Eine Schaltungsanordnung zur Arbeitspunkteinstellung 2 weist einen Ausgang 26, der einen eingeprägten Strom führt, der in die Basis des Transistors 1 einkoppelt. Der Arbeitspunkt des Transistors 1 wird eingestellt, indem der Transistor 1 mit einem durch den Widerstand 3 eingestellten Kollektorstrom IC und einem hierzu angepaßten Basisstrom IB versorgt wird. Je ein den Anschlüssen 10 und 11 zugeordneter Abblockkondensator 18 bzw. 17 dient zum Abblokken der Gleichströme IB bzw. IC vom Ein- und Ausgangsanschluß. Darüber hinaus sind im Last- oder Kollektorstrompfad eine Induktivität 13 sowie in der Basisstromzuführung eine Induktivität 14 in Reihe mit einem Widerstand 15 vorgesehen sowie eine jeweilige nach Masse geschaltete Kapazität 12 bzw. 16, um das zu verstärkende Hochfrequenzsignal von der Gleichstromzuführung zu entkoppeln.

Die Schaltung zur Arbeitspunkteinstellung 2 weist einen Anschluß 23 für das positive Versorgungspotential VS auf, einen Anschluß 24, an den der Meßwiderstand 3 des Kollektorstrompfads des Verstärkertransistors 1 angeschlossen ist und einen Anschluß 25 für Bezugspotential GND. Der eingeprägte, in Abhängigkeit von der Versorgungsspannung VS, GND und dem durch den Meßwiderstand 3 fließenden Strom geregelte Basisstrom ist an einem Anschluß 26 abgreifbar. Die Schaltung 2 weist ein Differenzglied 20 auf, das von der Versorgungsspannung VS, GND gespeist wird. Der Minus-Eingang des Differenzglieds 20 ist mit einer Referenzspannungsquelle 21 verbunden, die an den Anschluß 23 für das Versorgungspotential VS angelegt ist. Der Plus-Eingang des Differenzglieds 20 ist an den Anschluß 24 geführt und greift die am Meßwiderstand 3 abfallende Spannung ab. In Abhängigkeit von der vom Differenzglied 20 ermittelnden Spannungsdifferenz wird eine Stromquelle 22 gesteuert, welche den Basisstrom IB am Anschluß 26 bereitstellt.

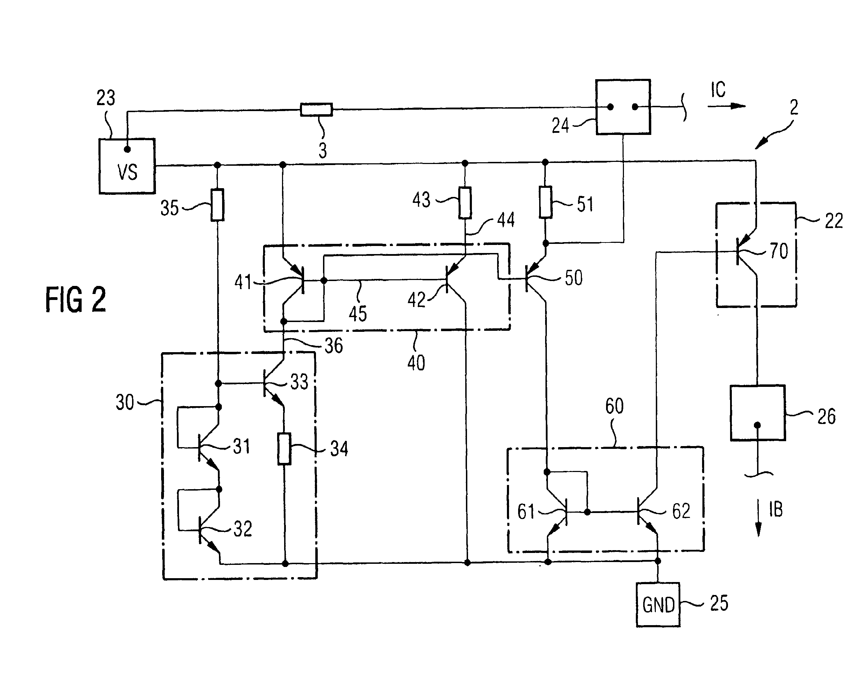

Die Ausführung der Schaltungsanordnung 2 ist in Figur 2 im Detail dargestellt. Entsprechende Elemente sind mit gleichen Bezugszeichen versehen. Die Schaltung weist eine Stromquelle 30 auf, die an den Bezugspotentialanschluß 25 angeschlossen ist und ausgangsseitig an einem Anschluß 26 einen Konstantstrom bereitstellt. Die Stromquelle umfaßt einen Bipolartransistor 33, dessen Emitter über einen Widerstand 34 mit dem Bezugspotentialanschluß 25 verbunden ist. Die Basis des Transistors 33 ist über zwei in Reihe geschaltete Bipolardioden 31, 32 mit dem Bezugspotentialanschluß 25 verbunden. Über einen Widerstand 35 wird der Reihenschaltung der Dioden 31, 32 ein Strom vom Anschluß 23 für das positive Versorgungspotential VS zugeführt. Der am Anschluß 36 der Stromquelle 30 gelieferte Konstantstrom wird in den Eingangszweig einer Stromspiegelschaltung 40 eingekoppelt. Die Stromspiegelschaltung 40 umfaßt eingangsseitig einen Bipolartransistor 41, dessen Kollektor und Basis miteinander verbunden sind. Der Kollektoranschluß des Transistors 41 ist mit der Stromquelle 30 verbunden, der Emitteranschluß mit dem Anschluß 23 für das positive Versorgungspotential VS. Der Ausgangszweig des Stromspiegels 40 enthält einen Bipolartransistor 42, dessen Kollektor direkt an den Bezugspotentialanschluß 25 angeschlossen ist und dessen Emitter über einen Widerstand 43 an den Versorgungspotentialanschluß 23 angeschlossen ist. Der Transistor 42 kann im Vergleich zum Transistor 41 einen höheren Strom führen. Er ist als Multiemittertransistor ausgeführt oder als Parallelschaltung mehrerer Transistoren. Basisseitig ist der Transistor 42 mit der Basis des Transistors 41 verbunden. Der von der Stromquelle 36 gelieferte Konstantstrom wird über den Stromspiegel 40 entsprechend verstärkt an den Widerstand 43 bereitgestellt, so daß sich am stromspiegelseitigen Anschluß 44 des Widerstands 43 eine auf das positive Versorgungspotential VS bezogene Konstantspannung einstellt.

Ein weiterer Bipolartransistor 50 weist emitterseitig einen Widerstand 51 auf, der an den Versorgungspotentialanschluß 23 angeschlossen ist. Die Basis des Transistors 50 ist an die Verbindungsleitung 45 zwischen den die Eingangs- und Ausgangszweige bildenden Transistoren 41, 42 des Stromspiegels 40 geschaltet, also die Verbindungsleitung der Basisanschlüsse der Transistoren 41, 42. Der Emitter des Transistors 50 ist außerdem an den Anschluß 24 angeschlossen, an welchem der Meßwiderstand 3 für den Kollektorstrom des Hochfrequenzverstärkertransistors 1 liegt. Der Transistor 50 wird also in Basisschaltung betrieben. In Abhängigkeit von dem durch den Meßwiderstand 3 fließenden Strom wird die Basis-Emitter-Spannung des Transistors 50 und somit dessen Kollektorstrom beeinflußt. Im einzelnen wird die am Meßwiderstand 3 abfallende Spannung mit der am Schaltungsknoten 44 oder Widerstand 43 anliegenden Konstantspannung verglichen und in Abhängigkeit von der Spannungsdifferenz zwischen der am Widerstand 3 abfallenden Spannung und der am Widerstand 43 anliegenden Konstantspannung der Kollektorstrom des Bipolartransistors 50 eingestellt. Der Kollektorstrom des Transistors 50 wird über einen an den Bezugspotentialanschluß 25 angeschlossene Stromspiegel 60 gespiegelt und dem Basisanschluß eines die Stromquelle 22 bildenden Bipolartransistors 70 zugeführt. Der Stromspiegel 60 umfaßt eingangsseitig einen Transistor 61 mit gekoppelten Kollektor- und Basisanschlüssen sowie ausgangsseitig einen Transistor 62, dessen Basis mit der Basis des Transistors 61 verbunden ist. Der Kollektor des Transistors 62 ist mit der Basis des Transistors 70 verbunden. Günstigerweise wird der Strom zwischen Eingangs- und Ausgangspfad des Stromspiegels 60 verstärkt, beispielsweise verdoppelt, indem der Transistor 62 als Doppelemittertransistor ausgeführt ist. Der Emitter des Transistors 70 liegt auf dem Potential VS, der Transistor 70 wird also in Emitterschaltung betrieben.

Alternativ zu einem einzigen Transistor 70 kann auch eine (nicht dargestellte) Darlington-Schaltung aus zwei oder mehreren Transistoren die Stromquelle 22 bilden. Im Vergleich zu einem einzigen Transistor weist die Darlington-Schaltung eine höhere Stromtreiberfähigkeit auf. Bei einer aus zwei pnp-Transistoren gebildeten Darlington-Schaltung ist der Emitteranschluß des ersten Darlington-Transistors mit dem Anschluß 23 verbunden. Der Emitter des zweiten Darlington-Transistors ist mit der Basis des ersten Darlington-Transistors verbunden. Die Basis des zweiten Darlington-Transistors ist mit dem Ausgangszweig des Stromspiegels 60 verbunden. Die Kollektoranschlüsse der Darlington-Transistoren sind miteinander verbunden und sind an den Ausgangsanschluß 26 angeschlossen.

Durch die Schaltungsanordnung zur Arbeitspunkteinstellung für den Hochfrequenztransistor 1 wird also in Abhängigkeit von einem aufgrund der Stromquelle 30 bereitgestellten Konstantstrom am Widerstand 43 eine Konstantspannung erzeugt, und weiterhin durch Differenzbildung mittels der an ihren Basisanschlüssen gekoppelten Transistoren 42, 50 mit der am Transistor 50 eingekoppelten Meßspannung ein von dieser Differenz abhängiger Kollektorstrom des Transistors 50 erzeugt, der nach Spiegelung und Verstärkung als Ausgangsstrom am Anschluß 26 bereitsteht.

Die Transistoren 31, 32, 33 der Stromquelle 30 sowie die Transistoren 61, 62 des Stromspiegels 60 sind npn-Bipolartransistoren. Die Transistoren 41, 42 des Stromspiegels 40 sowie der Transistor 50 und der Stromquellentransistor 22 sind pnp-Bipolartransistoren. Der Laststrompfad eines jeden der npn- und pnp-Transistoren ist dessen Kollektor-Emitter-Strompfad. Der Steueranschluß eines jeden Transistors ist dessen Basisanschluß. Die beschriebene Ausführung ermöglicht einen Betrieb bei geringer Spannung. Bereits bei einer Betriebsspannung VS, GND von 2 V setzt die Regelung ein. Die Schaltung weist eine überschaubare Anzahl von Transistoren und Widerständen auf, die bei integrierter Realisierung einen nur geringen Bedarf an Siliziumfläche erfordern. Die monolithisch integrierte Schaltung kann ohne weiteres in einem kleinen standardgemäßen 4-Pin-Gehäuse unterbracht werden.

Anstelle der Realisierung in einer bipolaren Halbleitertechnologie wie gezeigt kann die Schaltung auch in MOS-Technologie realisiert werden. Anstelle der gezeigten Bipolartransistoren 31, 32, 33, 61, 62 können n-Kanal-MOS-Transistoren verwendet werden. Anstelle der gezeigten pnp-Bipolartransistoren 41, 42, 50, 22 können p-Kanal-MOS-Transistoren verwendet werden. Die Laststrompfade der MOS-Transistoren sind deren Drain-Source-Strecken. Die Steuerelektroden der MOS-Transistoren sind deren Gateelektroden.

Bekanntlich ist die an der Basis-Emitter-Strecke eines Bipolartransistors abfallende Spannung temperaturabhängig. Mit steigender Temperatur nimmt die Basis-Emitter-Spannung ab. Für ansteigende Temperatur weist die an der Basis-Emitter-Strecke des Transistors 50 abfallende Spannungsdifferenz einen negativen Koeffizienten auf, so daß der am Anschluß 26 bereitgestellte Basisstrom ebenfalls einen negativen Temperaturkoeffizienten hat. Dadurch wird der Kollektorstrom des bipolaren Hochfrequenzverstärkertransistors 1 abgeregelt. Das Temperaturverhalten der Schaltung 2 verläuft entgegengesetzt zum Temperaturverhalten des Transistors 1, so daß der Arbeitspunkt des Transistors 1 temperaturstabil bleibt.

## Patentansprüche

1. Schaltungsanordnung zur Arbeitspunkteinstellung eines Hochfrequenztransistors, umfassend:
- einen Anschluß (23) für ein erstes Versorgungspotential (VS) und einen Anschluß (25) für ein zweites Versorgungspotential (GND);
- einen Meßanschluß (24), an den ein Meßwiderstand (3) anzuschließen ist, der in Reihe mit dem Laststrompfad eines Hochfrequenztransistors (1) geschaltet ist;
- einen Ausgangsanschluß (26), an den ein Steueranschluß des Hochfrequenztransistors (1) zu koppeln ist;
- ein Differenzglied, das versorgungsspannungsmäßig mit den Anschlüssen (23, 25) für das erste und das zweite Versorgungspotential verbunden ist und einen ersten Signaleingang (-) aufweist, der mit einer Referenzspannungsquelle (21) verbunden ist, und einen zweiten Signaleingang (+) der mit dem Meßanschluß (24) verbunden ist;
- und eine vom Differenzglied (20) steuerbare Stromquelle (22), die mit dem Ausgangsanschluß (26) verbunden ist.

2. Schaltungsanordnung nach Anspruch 1,
**gekennzeichnet durch**
eine erste Stromspiegelschaltung (40) mit einem Eingangspfad (41), der mit einer an den Anschluß (25) für das zweite Versorgungspotential angeschlossenen Stromquelle (30) verbunden ist, und mit einem Ausgangspfad (42), der über eine Steuerleitung (45) mit dem Eingangspfad (41) gekoppelt ist und der über einen ersten Widerstand (43) mit dem Anschluß (23) für das erste Versorgungspotential verbunden ist, und durch einen ersten Transistor (50), dessen Basis mit der die Pfade der ersten Stromspiegelschaltung (40) verbindenden Steuerleitung (45) verbunden ist, dessen Emitter über einen zweiten Widerstand (51) mit dem Anschluß (23) für das erste Versorgungspotential (VS) und mit dem Meßanschluß (24) verbunden ist.

3. Schaltungsanordnung nach Anspruch 2,
**gekennzeichnet durch**
einen zweiten Transistor (70) in Emitterschaltung, dessen Basis über einen zweiten Stromspiegel (60) mit dem ersten Transistor (50) verbunden ist und dessen Kollektor mit dem Ausgangsanschluß (26) verbunden ist.

4. Schaltungsanordnung nach Anspruch 2 oder 3,
**dadurch gekennzeichnet**, daß
die Stromquelle (30) den Laststrompfad eines Transistors (33) enthält, daß der Laststrompfad einerseits mit dem Eingangszweig (41) des ersten Stromspiegels (40) verbunden ist und andererseits über einen Widerstand (34) mit dem Anschluß (25) für das zweite Versorgungspotential (GND) und daß der Steueranschluß dieses Transistors (33) über eine Reihenschaltung aus mindestens zwei Dioden (31, 32) mit dem Anschluß (25) für das zweite Versorgungspotential verbunden ist.

5. Schaltungsanordnung nach Anspruch 2 oder 3,
**dadurch gekennzeichnet**, daß der Eingangszweig (41) des ersten Stromspiegels (40) die Laststrecke eines Transistors aufweist, dessen Steueranschluß mit seiner Laststrecke gekoppelt ist, und daß der Ausgangszweig des ersten Stromspiegels (40) die Laststrecke eines weiteren Transistors (42) aufweist, dessen Steueranschluß mit dem Steueranschluß des Transistors (41) des Eingangszweigs gekoppelt ist.

6. Schaltungsanordnung nach Anspruch 5,
**dadurch gekennzeichnet**, daß
der zweite Stromspiegel (60) einen ersten Transistor (61) aufweist, dessen Laststrompfad mit dem Laststrompfad des zweiten Transistors (50) gekoppelt ist und dessen Steueranschluß mit seinem Laststrompfad gekoppelt ist, und einen zweiten Transistor (62), dessen Laststrompfad mit dem Steueranschluß des zweiten Transistors (70) verbunden ist, und daß die Steueranschlüsse der Transistoren (61, 62) des zweiten Stromspiegels (60) miteinander gekoppelt sind.

7. Schaltungsanordnung nach Anspruch 5,
**dadurch gekennzeichnet**, daß
die Transistoren (41, 42) des ersten Stromspiegels (40) pnp-Transistoren oder n-Kanal-MOS-Transistoren sind.

8. Schaltungsanordnung nach Anspruch 3,
**dadurch gekennzeichnet**, daß
der erste und der zweite Transistor (50, 70) pnp-Transistoren oder p-Kanal-MOS-Transistoren sind.

9. Schaltungsanordnung nach Anspruch 1 oder 2,
**gekennzeichnet durch**
Ausführung der Stromquelle (22) als eine Darlington-Schaltung mit mindestens zwei Transistoren.

10. Verstärkerschaltung mit einer Schaltungsanordnung nach einem der Ansprüche 1 bis 9,
**gekennzeichnet durch**
einen Widerstand (3), der zwischen den Anschluß (23) für das erste Versorgungspotential (VS) und den Meßanschluß (24) der Schaltungsanordnung geschaltet ist und einen Hochfrequenztransistor (1), dessen Kollektor mit dem Meßanschluß (24) der Schaltungsanordnung und dessen Basis mit dem Ausgangsanschluß (26) der Schaltungsanordnung gleichstrommäßig gekoppelt sind, dessen Basis mit einem Eingangsanschluß (10) für ein hochfrequentes Eingangssignal (RFIN) und dessen Kollektor mit einem Ausgangsanschluß (11) für ein hochfrequentes Ausgangssignal (RFOUT) gekoppelt sind.
